# EUROPÄISCHE PATENTSCHRIFT

(11) **EP 3 407 080 B1**
(45) Veröffentlichungstag und Bekanntmachung des Hinweises auf die Patenterteilung: **30.06.2021**
(21) Anmeldenummer: 18173485.6
(22) Anmeldetag: 22.05.2018
(51) Int. Cl.: G01R 33/34, G01R 33/422

(54) **NMR-PROBENKOPF MIT LÖSBARER HF-DICHTUNG**
NMR SAMPLE HEAD WITH RELEASABLE HF SEAL
TÊTE D'ÉCHANTILLON RMN À JOINT HF DÉTACHABLE

(30) Priorität: 24.05.2017 DE 102017208841
(43) Veröffentlichungstag der Anmeldung: 28.11.2018
(73) Patentinhaber: Bruker Switzerland AG, 8117 Fällanden (CH)
(72) Erfinder: Meister, Roger, 8132 Hinteregg (CH); Schmidig, Daniel, 8200 Schaffhausen (CH)
(74) Vertreter: Kohler Schmid Möbus Patentanwälte

(56) Entgegenhaltungen:
- DE-A1- 4 201 440
- DE-A1- 4 304 871
- US-A1- 2008 060 843
- US-A1- 2014 354 279
- NICOLA BERTOLINO ET AL: "Design and characterization of an RF shield for a 400 MHz birdcage coil in a retrofitted PET camera for preclinical PET-MRI", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HAWAII, USA, 22-27 APRIL 2017, Nr. 2714, 7. April 2017 (2017-04-07), Seite 2714, XP040690282,
- CHUNQI QIAN ET AL: "A volume birdcage coil with an adjustable sliding tuner ring for neuroimaging in high field vertical magnets:andapplications at 21.1T", JOURNAL OF MAGNETIC RESONANCE, Bd. 221, 2012, Seiten 110-116, XP028424415, ISSN: 1090-7807, DOI: 10.1016/J.JMR.2012.05.016 [gefunden am 2012-05-30]

## Beschreibung

Die Erfindung betrifft einen NMR(=Kernspinresonanz)-Probenkopf mit einer oder mehreren um eine vorzugsweise vertikale z-Achse angeordneten HF(=Hochfrequenz)-Spulen sowie einem HF-Netzwerk, die von einer Einrichtung zum Abschirmen gegen äußere HF-Strahlung umgeben sind, welche ein elektrisch leitfähiges, längs der z-Achse angeordnetes Abschirmrohr umfasst, das um die HF-Spulen und das HF-Netzwerk in z-Richtung auf eine Basisscheibe des NMR-Probenkopfes geschoben werden kann, wobei mit axialem Abstand von der Basisscheibe eine Abschirmscheibe vorgesehen ist.

Ein derartiger NMR-Probenkopf ist beschrieben in der DE 43 04 871 A1 (=Referenz [0]).

Eine ähnliche Anordnung ist beispielsweise bekannt aus der Firmen-Druckschrift «HF immunity modifications» der Bruker BioSpin AG, Industriestrasse 26, CH-8117 Fällanden, Schweiz, aus dem Jahre 2007 (= Referenz [1]).

### Hintergrund der Erfindung

Die NMR-Spektroskopie stellt ein leistungsfähiges Verfahren der instrumentellen Analytik dar. Dabei werden in eine Messprobe, die sich in einem starken, statischen Magnetfeld befindet, HF-Pulse eingestrahlt, und die HF-Reaktion der Messprobe wird vermessen. Sodann werden die Informationen integral über einen gewissen Bereich der Messprobe, das sogenannte aktive Volumen, gewonnen. Die Messprobe besteht in der Regel aus einem zylindrischen Probenröhrchen, das die zu untersuchende Messsubstanz in fester oder flüssiger Form enthält. Das Probenröhrchen befindet sich typischerweise in einem Spinner. Probenröhrchen und Spinner werden mit Hilfe eines Transportsystems von außerhalb des Magneten in den NMR-Probenkopf transportiert. Wenn sich das Probenröhrchen in der Messposition befindet, dann ist der Spinner innerhalb der Turbine. Die Turbine ermöglicht eine Rotation des Probenröhrchens. In der Messposition ist das Probenröhrchen von einer oder mehreren NMR-Spulen umgeben. Die innerste NMR-Spule hat einen Innendurchmesser, der möglichst wenig größer als der Außendurchmesser der Messprobe ist, da der Füllfaktor und damit die Empfindlichkeit der NMR-Spule vom Innendurchmesser abhängt und mit steigendendem Innendurchmesser abfällt.

Um das HF-Netzwerk elektrisch "abzudichten", wird eine HF-Dichtung verwendet. Wenn diese HF-Dichtung jedoch relativ weit oben am NMR-Probenkopf platziert werden soll, muss fast das komplette Abschirmrohr über dies Dichtung gefahren werden. Dieser Vorgang kann unter anderem zu Schäden an der Dichtung führen. Außerdem ist eine relativ große Kraft erforderlich, um das Abschirmrohr zu montieren oder zu demontieren, was wiederum Schäden an der Dichtung und auch am HF-Aufbau hervorrufen kann. Neben der HF-Dichtigkeit ist auch ein guter elektrischer Massekontakt erwünscht.

### Nachteile des Standes der Technik

Bei der Montage des Abschirmrohrs gemäß dem Stand der Technik wird dieses über die HF-Dichtung gestreift. Das generiert eine relativ große Kraft in axialer (Montage-)Richtung. Durch diese Kraft und die Kanten der Bauteile kann damit die HF-Dichtung aufgrund von hoher Reibung und daraus resultierendem Abscheren zerstört werden.

Bei dem derzeitig im Stand der Technik verwendeten Konzept der sogenannten «SmartProbe» (siehe Referenz [1]) ist die HF-Dichtung ganz unten bei der Basisscheibe platziert. Beim neuen Konzept, der sogenannten iProbe, ist diese Dichtung aus konzeptionellen Gründen auf halber Höhe platziert worden. Bei gleichbleibendem HF-Dichtungskonzept würde bei der Montage des Abschirmrohrs bei der iProbe eine HF-Dichtung mit an Sicherheit grenzender Wahrscheinlichkeit zerstört werden, da das Abschirmrohr eine sehr lange Strecke über die Dichtung gestreift wird. Zudem sind die hohen Kräfte in der Produktion nicht so präzise kontrollierbar, dass durch die Montage kein Schaden an anderen Bauteilen entsteht.

### Aufgabe der Erfindung

Der vorliegenden Erfindung liegt demgegenüber die Aufgabe zugrunde, einen NMR-Probenkopf der eingangs definierten Art mit möglichst einfachen technischen Maßnahmen so zu modifizieren, dass die oben aufgezählten Nachteile weitestgehend vermieden werden, wobei das Abschirmohr kraftlos montiert und demontiert werden kann und trotzdem, nach dem Anziehen des Spannrings, eine genügend große Kontaktkraft zwischen den Bauteilen vorhanden ist, um damit eine ausreichend gute elektrische Leitung zwischen den Teilen zu erhalten.

### Kurze Beschreibung der Erfindung

Diese komplexe Aufgabe wird auf ebenso überraschend einfache wie wirkungsvolle Weise dadurch gelöst, dass bei einem gattungsgemäßen NMR-Probenkopf mit den eingangs definierten Merkmalen zwischen der Abschirmscheibe und dem Abschirmrohr im montierten Zustand eine spannbare HF-Dichtung angeordnet ist, die geometrisch so gestaltet ist, dass in einem ersten Montagezustand das Abschirmrohr unverspannt und kraftfrei über die Abschirmscheibe geschoben werden kann, und dass in einem zweiten Montagezustand die HF-Dichtung zwischen der Abschirmscheibe und dem Abschirmrohr mechanisch derart verspannbar ist, dass eine elektrisch leitende Verbindung zum Abschirmrohr über den Umfang der Abschirmscheibe gewährleistet ist.

Der erfindungsgemäße NMR-Probenkopf weist also zusätzlich zur üblichen Basisscheibe mit axialem Abstand von dieser auch eine Abschirmscheibe auf. Zudem ist dazwischen eine spannbare HF-Dichtung vorgesehen, die in einem ersten Montagezustand unverspannt ist und daher kraftfrei über die Abschirmscheibe geschoben werden kann, was die oben beschriebene Gefahr einer Beschädigung ganz erheblich mindert. Nach der Montage des Abschirmrohrs wird dann die Dichtung verspannt, um den Betriebszustand des NMR-Probenkopfes herzustellen. Damit wird einerseits eine sehr gute HF-Abdichtung, andererseits eine vorzügliche elektrische Massenanbindung erreicht.

An dieser Stelle sei ausdrücklich darauf hingewiesen, dass zwar in der Beschreibung der vorliegenden Erfindung sowie in den Patentansprüchen - der sprachlichen Einfachheit halber - stets von einer "vertikalen z-Achse" sowie von axialen Positionen "oberhalb" beziehungsweise "unterhalb" des NMR-Spulensystems die Rede ist, dass sich jedoch die Vorteile der Erfindung ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Spulensystems liegen, sondern gegebenenfalls auch "rechts" oder "links" neben demselben. Jedenfalls spielt die Schwerkraft bei der Wirkungsweise der vorliegenden Erfindung eine untergeordnete Rolle.

### Bevorzugte Ausführungsformen der Erfindung

In der Praxis bewähren sich besonders Ausführungsformen des erfindungsgemäßen NMR-Probenkopfes, bei denen das Abschirmrohr Prisma-förmig, vorzugsweise Zylinderförmig aufgebaut ist, was unter anderem eine einfache Herstellung sowie Handhabung ermöglicht.

Vorteilhaft ist eine Klasse von Ausführungsformen des erfindungsgemäßen NMR-Probenkopfes, bei der das Abschirmrohr in z-Richtung mindestens zweiteilig, insbesondere mehrteilig aufgebaut ist. Auf diese Weise kann das - aus der Sicht der heute üblichen konventionellen Fertigung- ziemlich lange Abschirmrohr so unterteilt werden, dass zum einen kürzere und damit produktionstechnisch einfacher herstellbare Abschnitte entstehen, und zum anderen die Abschnitte in einen -was die Dimensionen betrifft- Abschnitt mit geringeren Fertigungstoleranzen und einen "ungenaueren" Abschnitt unterteilt werden können, was sich insgesamt positiv auf die Herstellungskosten auswirkt.

Bei bevorzugten Weiterbildungen dieser Klasse von Ausführungsformen weist das Abschirmrohr einen ersten Teilabschnitt auf, welcher im Betriebszustand des NMR-Probenkopfes eine Messprobe bis unterhalb der Abschirmscheibe umgibt. Der genaue Abschnitt des Abschirmrohrs braucht dann gerade nur so lang zu sein, wie es die Ausdehnung des abzuschirmenden HF-Bereich unbedingt erfordert.

Besonders bevorzugt sind Varianten dieser Weiterbildungen, die sich dadurch auszeichnen, dass der erste Teilabschnitt des Abschirmrohres eine einheitliche Länge zwischen 100mm und 500mm, vorzugsweise um 300mm, aufweist, während ein zweiter Teilabschnitt des Abschirmrohres mit einer wählbaren, beliebigen Länge in z-Richtung, vorzugsweise als zylindrisches Rohr, gestaltet ist. Ein wesentlicher Vorteil besteht darin, dass der genaue Abschnitt des Abschirmrohrs für alle Varianten von Probenkopflängen stets der gleiche ist. Daraus ergibt sich, dass insbesondere hochgenaue Teile in einer größeren Stückzahl hergestellt werden können, was sich wiederum positiv auf die Herstellungskosten auswirkt. Bei einer zylindrischen Form des ersten Teilabschnitts des Abschirmrohres ist das Spannen der Dichtung besonders einfach zu gestalten und die Herstellung vereinfacht sich ebenfalls.

Andere Weiterbildungen der oben beschriebenen Klasse von Ausführungsformen der Erfindung sind dadurch gekennzeichnet, dass die Teilabschnitte des mehrteiligen Abschirmrohres vor ihrer Montage in den NMR-Probenkopf stoffschlüssig miteinander verbunden, insbesondere verklebt oder verschweißt sind. Damit wird eine sehr platzsparende Verbindung ermöglicht. Nach dem Verkleben kann dann das mehrteilige Abschirmrohr wie ein bewährtes einteiliges Abschirmrohr weiterbehandelt werden.

Vorteilhafte Weiterbildungen der vorher beschriebenen Ausführungsformen können zudem vorsehen, dass das Abschirmrohr, zumindest dessen erster Teilabschnitt, eine elektrische Leitfähigkeit σ ≥ 30*10⁶ Siemens/Meter aufweist. Hier muss nur der erste Teilabschnitt eine elektrisch leitende (und damit teurere) Schicht aufweisen. Der zweite Teilabschnitt kann ganz einfach und günstig beispielsweise eloxiert werden.

Besonders bevorzugt ist auch eine Klasse von Ausführungsformen, bei welchen die spannbare HF-Dichtung ein Federelement enthält, welches im zweiten Montagezustand gegen einen Randabschnitt der Abschirmscheibe drückt. So kann eine Mindestanpresskraft generiert werden ohne eine plastische Deformation der Finger zu provozieren. Gleichzeitig können Herstellungstoleranzen im System Abschirmscheibe - HF-Dichtung - Abschirmrohr aufgenommen werden.

Bei vorteilhaften Weiterbildungen dieser Ausführungsformen ist der Randabschnitt der Abschirmscheibe konisch gestaltet, so dass damit eine längenunabhängige Verspannung der Kontaktfedern erreicht werden kann. Egal ob ein bisschen mehr oder weniger Kraft anliegt, die Federn sind immer am richtigen Ort.

Bevorzugt ist auch eine Ausführungsform des erfindungsgemäßen NMR-Probenkopfs, die sich dadurch auszeichnet, dass radial zwischen dem Abschirmrohr und der Abschirmscheibe ein Spannring angeordnet ist. Mit diesem Spannring kann eine Drehbewegung zum Spannen der HF-Dichtung erlaubt werden, ohne dass die HF-Dichtung sich selber dreht.

Eine Weiterbildung dieser und/oder der vorher beschriebenen Ausführungsform sieht vor, dass das Federelement eine Vielzahl von Kontaktfingern aufweist, die mit Hilfe des Spannrings über einen Konus zwischen die Abschirmscheibe und das Abschirmrohr gedrückt werden und dadurch einen elektrischen Kontakt zwischen Abschirmrohr und Abschirmscheibe herstellen. Durch eine Unterteilung des Kontaktes in viele kleine Kontakte kann jederzeit ein sauberer Kontakt am Umfang gewährleistet werden.

Weitere vorteilhafte Varianten dieser und/oder der vorher beschriebenen Weiterbildungen sehen vor, dass der konische Randabschnitt der Abschirmscheibe so ausgebildet ist, dass keine Selbsthemmung der Kontaktfinger beim Lösen der HF-Dichtung auftritt, wobei insbesondere der Konuswinkel ≥ 15° ist. Bei der Wahl des richtigen Winkels kann die HF-Dichtung immer wieder in die ungespannte Position, in der das Abschirmrohr kraftfrei montiert werden kann, zurückgleiten.

In den Rahmen der Erfindung fällt auch ein Verfahren zum Betrieb des erfindungsgemäßen NMR-Probenkopfes, das dadurch gekennzeichnet ist, dass mittels eines Spannschlüssels die spannbare HF-Dichtung gespannt oder gelöst wird. Durch die Verwendung eines speziellen Spannschlüssels wird ein Lösen des Spannrings im Feld verhindert. Nebenbei braucht man sowieso ein Element um den Spannring zu spannen.

Vorteilhafte Varianten dieses Verfahrens zeichnen sich dadurch aus, dass der Spannschlüssel zum Spannen oder Lösen der HF-Dichtung seitlich oder von unten vorübergehend angebracht wird.

In den Rahmen der vorliegenden Erfindung fällt auch eine NMR-Messanordnung mit einem erfindungsgemäßen NMR-Probenkopf der oben beschriebenen Art, die auch ein NMR-Magnetsystem, ein Shimsystem, eine Turbine sowie eine Vorrichtung zum Transport eines Probenröhrchens von außerhalb des NMR-Magnetsystems bis in die Messposition des Probenröhrchens im NMR-Probenkopf umfassen kann. Die erfindungsgemäße lösbare HF-Dichtung kommt insbesondere im Gesamtsystem von NMR-Probenkopf, NMR-Magnet und Transportvorrichtung zum Tragen, da diese Kombination automatische Wechsel der Probenröhrchen erlaubt, die z.B. bei Hochdurchsatz-NMR-Anwendungen sehr wichtig sind. Die erfindungsgemäße Anordnung leistet für diese Anwendungen einen wichtigen Beitrag, da sie eine Beschädigung des NMR-Probenkopfes beim Einführen der HF-Dichtung verhindert.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern dadurch der durch die Ansprüche definierte Schutzbereich der Erfindung nicht verlassen wird. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine Ausführungsform des erfindungsgemäßen NMR-Probenkopfs in schematischem Vertikalschnitt in einem unverspannten ersten Montagezustand der HF-Dichtung vor deren Montage oder *nach* ihrer Demontage;
- Fig. 1b: die Ausführungsform nach Fig. 1a *nach* der Montage der HF-Dichtung, betriebsbereit im verspannten zweiten Montagezustand; und
- Fig. 2: eine schematische vertikale Halbschnittdarstellung mit Details einer Ausführungsform des erfindungsgemäßen NMR-Probenkopfs im Bereich der spannbaren HF-Dichtung.

Die vorliegende Erfindung befasst sich mit der beschädigungsfreien Montage einer HF-Dichtung in einen NMR-Probenkopf.

Ein solcher **NMR-Probenkopf 1** umfasst gattungsgemäß eine oder mehrere um eine **vertikale Symmetrieachse z** einer NMR-Magnetspulenanordnung angeordnete **HF-Spulen 2** sowie einem **HF-Netzwerk 3,** die von einer **Einrichtung 4 zum Abschirmen gegen äußere HF-Strahlung** umgeben sind, welche ein elektrisch leitfähiges, längs der z-Achse angeordnetes **Abschirmrohr** 5 umfasst, das um die HF-Spulen 2 und das HF-Netzwerk 3 in z-Richtung auf eine **Basisscheibe 6** geschoben werden kann.

Die vorliegende Erfindung ist dadurch charakterisiert, dass mit axialem Abstand von der Basisscheibe 6 eine **Abschirmscheibe 7** vorgesehen ist, dass zwischen der Abschirmscheibe 7 und dem Abschirmrohr 5 im montierten Zustand eine **spannbare HF-Dichtung 8** angeordnet ist, die geometrisch so gestaltet ist, dass in einem ersten Montagezustand das Abschirmrohr 5 unverspannt und kraftfrei über die Abschirmscheibe 7 geschoben werden kann, und dass in einem zweiten Montagezustand die HF-Dichtung 8 zwischen der Abschirmscheibe 7 und dem Abschirmrohr 5 mechanisch derart verspannbar ist, dass eine elektrisch leitende Verbindung zum Abschirmrohr 5 über den Umfang der Abschirmscheibe 7 gewährleistet ist.

Bei den in den Figuren der Zeichnung gezeigten Ausführungsformen ist das Abschirmrohr 5 Prisma-förmig, insbesondere zylindrisch, sowie in z-Richtung mindestens zweiteilig aufgebaut. Ein **erster Teilabschnitt 5.1** umgibt im Betriebszustand des NMR-Probenkopfes 1 eine Messprobe bis unterhalb der Abschirmscheibe 7. Dieser erste Teilabschnitt 5.1 weist eine einheitliche Länge zwischen 100mm und 500mm auf, während ein **zweiter Teilabschnitt 5.2** des Abschirmrohres 5 mit einer wählbaren, beliebigen Länge in z-Richtung, vorzugsweise als zylindrisches Rohr, gestaltet ist. Die Teilabschnitte 5.1, 5.2 des mehrteiligen Abschirmrohres 5 werden vor ihrer Montage in den NMR-Probenkopf 1 stoffschlüssig miteinander verbunden, insbesondere verklebt oder verschweißt.

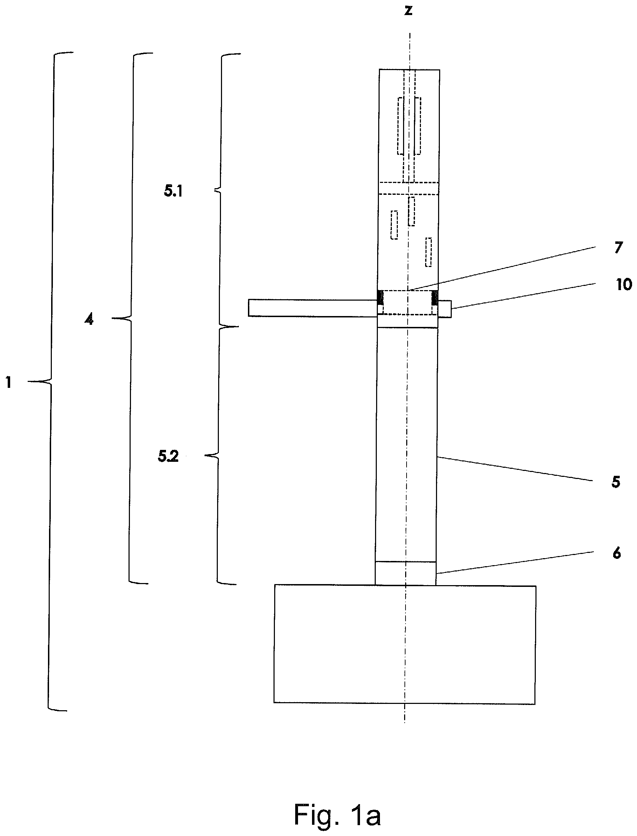

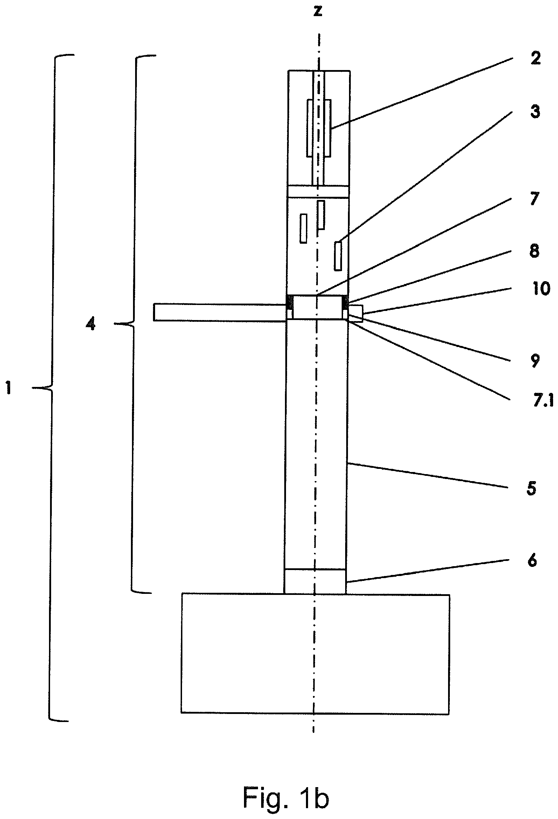

Die Figuren 1a und 1b veranschaulichen schematisch eine Ausführungsform des NMR-Probenkopfes 1 gemäß der vorliegenden Erfindung, wie er im Detail hier beschrieben ist, mit einer Vorrichtung zur beschädigungsfreien Montage und Demontage der HF-Dichtung 8. Während Fig. 1a die spannbare HF-Dichtung 8 in einem noch nicht montierten beziehungsweise wieder demontierten, unverspannten und damit kraftfreien ersten Montagezustand darstellt, zeigt Fig. 1b die Situation im montierten, betriebsfertigen zweiten Montagezustand in welchem die HF-Dichtung 8 zwischen der Abschirmscheibe 7 und dem Abschirmrohr 5 mechanisch verspannt ist.

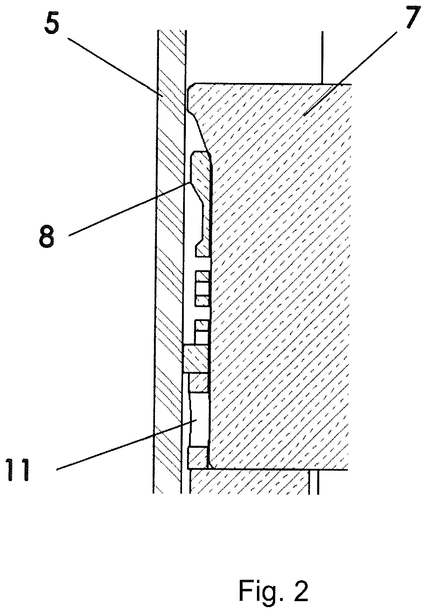

Wie in Fig. 2 gut erkennbar, enthält die spannbare HF-Dichtung 8 ein Federelement, welches im zweiten Montagezustand gegen einen **Randabschnitt 7.1** der Abschirmscheibe 7 drückt. Dieser Randabschnitt 7.1 der Abschirmscheibe 7 ist konisch gestaltet.

Radial zwischen dem Abschirmrohr 5 und der Abschirmscheibe 7 ist ein **Spannring 9** angeordnet. Das in der Zeichnung nicht näher dargestellte Federelement kann eine Vielzahl von Kontaktfingern aufweisen, die mit Hilfe des Spannrings 9 über einen Konus zwischen die Abschirmscheibe 7 und das Abschirmrohr 5 gedrückt werden und dadurch einen elektrischen Kontakt zwischen Abschirmrohr 5 und Abschirmscheibe 7 herstellen. Der konische Randabschnitt 7.1 der Abschirmscheibe 7 ist so ausgebildet, dass keine Selbsthemmung der Kontaktfinger beim Lösen der HF-Dichtung 8 auftritt, wobei insbesondere der Konuswinkel ≥ 15° ist.

Außerdem ist ein **Spannschlüssel 10** vorgesehen, mittels welchem die spannbare HF-Dichtung 8 gespannt oder gelöst werden kann, wie in den Figuren 1a und 1b veranschaulicht. Dabei kann der Spannschlüssel 10 zum Spannen oder Lösen der HF-Dichtung 8 seitlich oder von unten vorübergehend angebracht werden.

### Bezugszeichenliste:

- 1: NMR-Probenkopf
- 2: HF-Spulen
- 3: HF-Netzwerk
- 4: Einrichtung zum Abschirmen gegen äußere HF-Strahlung
- 5: Abschirmrohr
- 5.1: erster Teilabschnitt des Abschirmrohres
- 5.2: zweiter Teilabschnitt des Abschirmrohres
- 6: Basisscheibe
- 7: Abschirmscheibe
- 7.1: konischer Randabschnitt der Abschirmscheibe
- 8: spannbare HF-Dichtung
- 9: Spannring
- 10: Spannschlüssel
- z: Symmetrieachse der Magnetspulenanordnung

### Referenzliste

[0] DE 43 04 871 A1
[1] Firmen-Druckschrift "HF immunity modifications» der Bruker BioSpin AG, Industriestrasse 26, CH-8117 Fällanden, Schweiz, aus dem Jahre 2007
[2] D. Schmidig, D. Al Adwan-Stojilkovic, D. Wilhelm: DE 10 2013 212 312 B4
[3] M. Warden, R. Seydoux, D. Marek: US 6,563,317 B2; EP 1 239 296 B1; DE 101 11 672 C2
[4] D. Marek: US 6,466,019 B2; EP 1 124 137 B1; DE 100 06 324 C1
[5] K. Nagao; K. Nakagawa: US-A 3525928
[6] B. Grossniklaus, F. Raffa, M. Mayer, D. Wilhelm: US 2011/0284192 A1; EP 2 388 609 A1; DE 102 01 0029 080 B4
[7] J. Hinderer, R. Schauwecker: DE 10 2016 214 731 B4

## Patentansprüche

1. NMR-Probenkopf (1) mit einer oder mehreren um eine vertikale Symmetrieachse (z) angeordneten HF-Spulen (2) sowie einem HF-Netzwerk (3), die von einer Einrichtung (4) zum Abschirmen gegen äußere HF-Strahlung umgeben sind, welche ein elektrisch leitfähiges, längs der z-Achse angeordnetes Abschirmrohr (5) umfasst, das um die HF-Spulen (2) und das HF-Netzwerk (3) in z-Richtung auf eine Basisscheibe (6) des NMR-Probenkopfes (1) geschoben werden kann, wobei mit axialem Abstand von der Basisscheibe (6) eine Abschirmscheibe (7) vorgesehen ist,
**dadurch gekennzeichnet,**
**dass** zwischen der Abschirmscheibe (7) und dem Abschirmrohr (5) im montierten Zustand eine spannbare HF-Dichtung (8) angeordnet ist, die geometrisch so gestaltet ist, dass in einem ersten Montagezustand das Abschirmrohr (5) unverspannt und kraftfrei über die Abschirmscheibe (7) geschoben werden kann,
und **dass** in einem zweiten Montagezustand die HF-Dichtung (8) zwischen der Abschirmscheibe (7) und dem Abschirmrohr (5) mechanisch derart verspannbar ist, dass eine elektrisch leitende Verbindung zum Abschirmrohr (5) über den Umfang der Abschirmscheibe (7) gewährleistet ist.

2. NMR-Probenkopf nach Anspruch 1, **dadurch gekennzeichnet, dass** das Abschirmrohr (5) Prisma-förmig aufgebaut ist.

3. NMR-Probenkopf nach Anspruch 1 oder 2, **dadurch gekennzeichnet, dass** das Abschirmrohr (5) in z-Richtung mindestens zweiteilig, insbesondere mehrteilig aufgebaut ist.

4. NMR-Probenkopf nach Anspruch 3, **dadurch gekennzeichnet, dass** das Abschirmrohr (5) einen ersten Teilabschnitt (5.1) aufweist, welcher im Betriebszustand des NMR-Probenkopfes (1) eine Messprobe bis unterhalb der Abschirmscheibe (7) umgibt.

5. NMR-Probenkopf nach Anspruch 4, **dadurch gekennzeichnet, dass** der erste Teilabschnitt (5.1) des Abschirmrohres (5) eine einheitliche Länge zwischen 100mm und 500mm aufweist, während ein zweiter Teilabschnitt (5.2) des Abschirmrohres (5) mit einer wählbaren, beliebigen Länge in z-Richtung, vorzugsweise als zylindrisches Rohr, gestaltet ist.

6. NMR-Probenkopf nach einem der Ansprüche 3 bis 5, **dadurch gekennzeichnet, dass** die Teilabschnitte (5.1, 5.2) des mehrteiligen Abschirmrohres (5) vor ihrer Montage in den NMR-Probenkopf (1) stoffschlüssig miteinander verbunden, insbesondere verklebt oder verschweißt sind.

7. NMR-Probenkopf nach einem der Ansprüche 3 bis 6, **dadurch gekennzeichnet, dass** das Abschirmrohr (5), zumindest dessen erster Teilabschnitt (5.1), eine elektrische Leitfähigkeit σ ≥ 30*10⁶ Siemens/Meter aufweist.

8. NMR-Probenkopf nach einem der vorhergehenden Ansprüche, **dadurch gekennzeichnet, dass** die spannbare HF-Dichtung (8) ein Federelement enthält, welches im zweiten Montagezustand gegen einen Randabschnitt (7.1) der Abschirmscheibe (7) drückt.

9. NMR-Probenkopf nach Anspruch 8, **dadurch gekennzeichnet, dass** der Randabschnitt (7.1) der Abschirmscheibe (7) konisch gestaltet ist.

10. NMR-Probenkopf nach einem der vorhergehenden Ansprüche, **dadurch gekennzeichnet, dass** radial zwischen dem Abschirmrohr (5) und der Abschirmscheibe (7) ein Spannring (9) angeordnet ist.

11. NMR-Probenkopf nach Anspruch 10 sowie einem der Ansprüche 8 oder 9, **dadurch gekennzeichnet, dass** das Federelement eine Vielzahl von Kontaktfingern aufweist, die mit Hilfe des Spannrings (9) über einen Konus zwischen die Abschirmscheibe (7) und das Abschirmrohr (5) gedrückt werden und dadurch einen elektrischen Kontakt zwischen Abschirmrohr (5) und Abschirmscheibe (7) herstellen.

12. NMR-Probenkopf nach den Ansprüchen 9 und 11, **dadurch gekennzeichnet, dass** der konische Randabschnitt (7.1) der Abschirmscheibe (7) so ausgebildet ist, dass keine Selbsthemmung der Kontaktfinger beim Lösen der HF-Dichtung (8) auftritt, wobei insbesondere der Konuswinkel ≥ 15° ist.

13. NMR-Messanordnung mit einem NMR-Probenkopf (1) nach einem der vorhergehenden Ansprüche, mit einem NMR-Magnetsystem, einem Shimsystem, einer Turbine sowie einer Vorrichtung zum Transport eines Probenröhrchens von außerhalb des NMR-Magnetsystems bis in die Messposition des Probenröhrchens im NMR-Probenkopf (1).

14. Verfahren zum Betrieb eines NMR-Probenkopfes (1) nach einem der vorhergehenden Ansprüche, **dadurch gekennzeichnet, dass** mittels eines Spannschlüssels (10) die spannbare HF-Dichtung (8) gespannt oder gelöst wird.

15. Verfahren nach Anspruch 14, **dadurch gekennzeichnet, dass** der Spannschlüssel (10) zum Spannen oder Lösen der HF-Dichtung (8) seitlich oder von unten vorübergehend angebracht wird.

## Claims

1. NMR probe head (1) comprising one or more RF coils (2) arranged around a vertical axis of symmetry (z), and an RF network (3), that are surrounded by an apparatus (4) for shielding from external RF radiation comprising an electrically conductive shielding tube (5) that is arranged along the z-axis and can be pushed around the RF coils (2) and the RF network (3) in the z direction towards a base disc (6) of the NMR probe head (1), wherein a shielding disc (7) is provided at an axial distance from the base disc (6),
**characterized in that**
in the mounted state, a tensible RF seal (8) is arranged between the shielding disc (7) and the shielding tube (5), which seal is geometrically designed such that, in a first mounting state, the shielding tube (5) can be pushed over the shielding disc (7) in an unbraced and force-free manner,
and that, in a second mounting state, the RF seal (8) can be mechanically braced between the shielding disc (7) and the shielding tube (5) such that an electrically conductive connection to the shielding tube (5) is ensured over the periphery of the shielding disc (7).

2. NMR probe head according to claim 1, **characterized in that** the shielding tube (5) is prism-shaped.

3. NMR probe head according to either claim 1 or claim 2, **characterized in that** the shielding tube (5) is formed in at least two parts, in particular in multiple parts, in the z-direction.

4. NMR probe head according to claim 3, **characterized in that** the shielding tube (5) comprises a first sub-portion (5.1) which, in the operating state of the NMR probe head (1), surrounds a test sample as far as below the shielding disc (7).

5. NMR probe head according to claim 4, **characterized in that** the first sub-portion (5.1) of the shielding tube (5) has a standard length of between 100 mm and 500 mm, while a second sub-portion (5.2) of the shielding tube (5) is designed having a selectable, arbitrary length in the z-direction, preferably as a cylindrical tube.

6. NMR probe head according to any of claims 3 to 5, **characterized in that** the sub-portions (5.1, 5.2) of the multiple-part shielding tube (5) are integrally interconnected, in particular adhesively bonded or welded, before being mounted in the NMR probe head (1).

7. NMR probe head according to any of claims 3 to 6, **characterized in that** the shielding tube (5), at least its first sub-portion (5.1), has an electrical conductivity of σ ≥ 30*10⁶ Siemens/meter.

8. NMR probe head according to any of the preceding claims, **characterized in that** the tensible RF seal (8) contains a spring element which, in the second mounting state, presses against an edge portion (7.1) of the shielding disc (7).

9. NMR probe head according to claim 8, **characterized in that** the edge portion (7.1) of the shielding disc (7) is conical.

10. NMR probe head according to any of the preceding claims, **characterized in that** a clamping ring (9) is arranged radially between the shielding tube (5) and the shielding disc (7).

11. NMR probe head according to claim 10 and to either claim 8 or claim 9, **characterized in that** the spring element comprises a plurality of contact fingers which are pressed, by means of the clamping ring (9), over a cone between the shielding disc (7) and the shielding tube (5) and thus establish electrical contact between the shielding tube (5) and the shielding disc (7).

12. NMR probe head according to claims 9 and 11, **characterized in that** the conical edge portion (7.1) of the shielding disc (7) is designed such that no self-locking of the contact fingers occurs when the RF seal (8) is released, the cone angle in particular being ≥ 15°.

13. NMR measurement assembly comprising an NMR probe head (1) according to any of the preceding claims, an NMR magnet system, a shim system, a turbine and a device for transporting a sample tube from outside the NMR magnet system into the measuring position of the sample tube in the NMR probe head (1).

14. Method of operating an NMR probe head (1) according to any of the preceding claims, **characterized in that** the tensible RF seal (8) can be clamped or released by means of a chuck key (10).

15. Method according to claim 14, **characterized in that** the chuck key (10) for clamping or releasing the RF seal (8) is temporarily attached at the side or from below.

## Revendications

1. Tête de sonde RMN (1) comprenant une ou plusieurs bobines HF (2), disposées autour d'un axe de symétrie vertical (z), et un réseau HF (3), lesquels sont entourés d'un moyen (4) de blindage contre le rayonnement HF extérieur qui comprend un tube de blindage (5) électriquement conducteur qui est disposé le long de l'axe z et qui peut coulisser autour des bobines HF (2) et du réseau HF (3) dans la direction z sur un disque de base (6) de la tête de sonde RMN (1), un disque de protection (7) étant prévu à une distance axiale du disque de base (6),
**caractérisé en ce que**
une garniture d'étanchéité HF (8) qui peut être serrée étant disposée à l'état monté entre le disque de protection (7) et le tube de protection (5) et étant géométriquement conçue de telle sorte que, dans un premier état de montage, le tube de protection (5) puisse coulisser sans contrainte et sans force sur le disque de blindage (7)
et **en ce que**, dans un deuxième état de montage, le garniture d'étanchéité HF (8) peut être serrée mécaniquement entre le disque de blindage (7) et le tube de blindage (5) de manière à établir une liaison électriquement conductrice au tube de blindage (5) sur la circonférence du disque de protection (7).

2. Tête de sonde RMN selon la revendication 1, **caractérisée en ce que** le tube de blindage (5) est réalisé sous la forme d'un prisme.

3. Tête de sonde RMN selon la revendication 1 ou 2, **caractérisée en ce que** le tube de blindage (5) est réalisé en au moins deux parties, notamment en plusieurs parties, dans la direction z.

4. Tête de sonde RMN selon la revendication 3, **caractérisée en ce que** le tube de blindage (5) comporte une première portion (5.1) qui, lorsque la tête de sonde RMN (1) est en fonctionnement, entoure un échantillon de mesure jusqu'au dessous du disque de blindage (7).

5. Tête de sonde RMN selon la revendication 4, **caractérisée en ce que** la première portion (5.1) du tube de blindage (5) a une longueur uniforme comprise entre 100 mm et 500 mm, tandis qu'une deuxième portion (5.2) du tube de blindage (5) est conçue de préférence comme un tube cylindrique ayant une longueur quelconque sélectionnable dans la direction z.

6. Tête de sonde RMN selon l'une des revendications 3 à 5, **caractérisée en ce que** les portions (5.1, 5.2) du tube de blindage (5) en plusieurs parties sont reliées les unes aux autres par une liaison de matière, notamment collées ou soudées, avant d'être montées dans la tête de sonde RMN (1).

7. Tête de sonde RMN selon l'une des revendications 3 à 6, **caractérisée en ce que** le tube de blindage (5), au moins dans sa première portion (5.1), a une conductivité électrique de σ ≥ 30*10⁶ Siemens/mètre.

8. Tête de sonde RMN selon l'une des revendications précédentes, **caractérisée en ce que** la garniture d'étanchéité HF (8) qui peut être serrée contient un élément à ressort qui, dans le deuxième état de montage, presse contre une portion de bord (7.1) du disque de blindage (7).

9. Tête de sonde RMN selon la revendication 8, **caractérisée en ce que** la portion de bord (7.1) du disque de blindage (7) est conique.

10. Tête de sonde RMN selon l'une des revendications précédentes, **caractérisée en ce qu'**une bague de serrage (9) est disposée radialement entre le tube de blindage (5) et le disque de blindage (7).

11. Tête de sonde RMN selon la revendication 10 et l'une des revendications 8 ou 9, **caractérisée en ce que** l'élément à ressort comporte une multitude de doigts de contact qui, à l'aide de la bague de serrage (9), sont pressés par le biais d'un cône entre le disque de blindage (7) et le tube de blindage (5) et établissent ainsi un contact électrique entre le tube de blindage (5) et le disque de blindage (7).

12. Tête de sonde RMN selon les revendications 9 et 11, **caractérisée en ce que** la portion de bord conique (7.1) du disque de blindage (7) est conçue pour qu'aucun auto-verrouillage des doigts de contact ne se produise lorsque la garniture d'étanchéité HF (8) est desserrée, en particulier l'angle de cône étant ≥ 15°.

13. Ensemble de mesure RMN comprenant une tête de sonde RMN (1) selon l'une des revendications précédentes, un système magnétique RMN, un système de cale, une turbine et un dispositif de transport d'un tube d'échantillon depuis l'extérieur du système magnétique RMN jusqu'à la position du tube d'échantillon dans la tête de sonde RMN (1).

14. Procédé de fonctionnement d'une tête de sonde RMN (1) selon l'une des revendications précédentes, **caractérisé en ce que** la garniture d'étanchéité HF (8) qui peut être serrée est serrée ou desserrée au moyen d'une clé de serrage (10).

15. Procédé selon la revendication 14, **caractérisé en ce que** la clé de serrage (10) est fixée temporairement latéralement ou depuis le bas pour serrer ou desserrer la garniture d'étanchéité HF (8).
